# EUROPÄISCHE PATENTSCHRIFT

(11) **EP 1 294 959 B1**
(45) Veröffentlichungstag und Bekanntmachung des Hinweises auf die Patenterteilung: **28.12.2005**
(21) Anmeldenummer: 01951436.3
(22) Anmeldetag: 26.06.2001
(51) Int. Cl.: C23C 16/32, C23C 16/40, C23C 14/08, C23C 16/511

(54) **VERFAHREN ZUR HERSTELLUNG EINER MULTIFUNKTIONALEN MEHRLAGEN SCHICHT AUF EINEM TRANSPARENTEN KUNSTSTOFFSUBSTRAT UND EINE DANACH HERGESTELLTE MULTIFUNKTIONALE MEHRLAGENSCHICHT**
METHOD FOR PRODUCING A MULTI-FUNCTIONAL, MULTI-PLY LAYER ON A TRANSPARENT PLASTIC SUBSTRATE AND A MULTI-FUNCTIONAL MULTI-PLY LAYER PRODUCED ACCORDING TO SAID METHOD
PROCEDE POUR PRODUIRE UN ENSEMBLE MULTICOUCHE MULTIFONCTIONNEL SUR UN SUBSTRAT EN MATIERE PLASTIQUE TRANSPARENT, ET ENSEMBLE MULTICOUCHE MULTIFONCTIONNEL PRODUIT SELON CE PROCEDE

(30) Priorität: 27.06.2000 DE 10031280
(43) Veröffentlichungstag der Anmeldung: 26.03.2003
(73) Patentinhaber: Roth & Rau AG, 09358 Wüstenbrand (DE)
(72) Erfinder: DITTRICH, Karl-Heinz, 09125 Chemnitz (DE); ROTH, Dietmar, 09353 Oberlungwitz (DE)
(74) Vertreter: Pätzelt, Peter
(86) Internationale Anmeldenummer: PCT/DE2001/002380
(87) Internationale Veröffentlichungsnummer: WO 2002/000961

(56) Entgegenhaltungen:
- DE-A- 19 854 645
- US-A- 5 362 552
- US-A- 5 424 131

## Beschreibung

### Technisches Gebiet

Die Erfindung betrifft ein Verfahren zur Herstellung einer multifunktionalen Mehrlagenschicht auf einem transparenten Kunststoffsubstrat, die optisch transparent, elektrisch leitfähig und kratzfest ist.

Des Weiteren betrifft die Erfindung eine nach dem Verfahren hergestellte multifunktionale Mehrlagenschicht. Derartige Mehrlagenschichten sind insbesondere zur Anwendung bei heizbaren Kunststoffscheiben für Fahrzeuge, Visiere u.ä. geeignet.

### Stand der Technik

Nach dem Stand der Technik ist eine Vielzahl von funktionellen Schichtsystemen bekannt, die auf Metall-, Keramik- oder Kunststoffsubstrate aufgebracht werden. Zur Herstellung derartiger Schichtsysteme sind u.a. auch verschiedene plasmagestützte Verfahren bekannt. Dabei ist grundsätzlich zwischen den Verfahren zu unterscheiden, bei denen, z.B. bei Metall- und Keramiksubstraten, Substrattemperaturen über 300 °C erforderlich sind und den Verfahren, bei denen, z.B. bei Kunststoffsubstraten, die Substrattemperatur auf 120 °C oder weniger begrenzt werden muss.

Die DE 19733053 A1 gibt eine transparente, niederohmige Beschichtung auf einem transparenten Substrat an. Diese Schicht dient z.B. dazu, auf Displays (Monitore), d.h. auf einem Glassubstrat, eine optische Schicht aufzubringen, die für Wellenlängen zwischen 400 und 600 nm eine Transmission über 80 % aufweist. Dazu wird unmittelbar auf dem Substrat eine Oxidschicht, eine transparente Metallschicht, eine zweite Oxidschicht, darauf eine weitere transparente Metallschicht und wiederum eine Oxidschicht aufgebaut. Als Oxidschicht wird eine ITO-Schicht (Indium-Zinn-Oxid-Schicht) und als Metallschicht eine Silberschicht, die einen Kupferanteil aufweisen kann, angegeben.

Die DE 19634334 C1 gibt eine wisch- und kratzfeste Reflexionsbeschichtung von optischen Reflektoren an. Der Schichtaufbau besteht aus einer Schichtkombination aus einer ersten harten Lack- oder Polymerschicht mit mindestens 1 bis 2 µm Dicke, einer optisch dichten Metallschicht mit 40 bis 100 nm Dicke und einer abschließenden harten, optisch transparenten, plasmagestützt abgeschiedenen Hexamethyldisiloxan (HMDS)-Schutzschicht mit 30 bis 100 nm Dicke.

Mit den bekannten plasmagestützten Verfahren, die mit Substrattemperaturen unter 120 °C arbeiten, sind nur Schichten mit sehr begrenzten funktionellen Eigenschaften herstellbar. Insbesondere die Herstellung elektrisch leitfähiger, transparenter und kratzfester Schichten und multifunktionale Mehrfachschichten ist dem Stand der Technik nicht möglich. Die Ursache liegt im Wesentlichen darin, dass der Energieeintrag auf die plasmagestützt abgeschiedene leitfähige Schicht, bei dem das Substrat nicht über 120°C aufgeheizt werden darf, nicht ausreicht, eine ausreichend dichte und damit gut leitfähige und kratzfeste Schicht abzuscheiden.

### Darstellung der Erfindung

Der Erfindung liegt damit als Aufgabe zu Grunde, ein Verfahren zur Herstellung einer multifunktionalen Mehrlagenschicht auf transparenten Kunststoffen anzugeben, die elektrisch leitfähig, transparent und kratzfest ist. Eine weitere Aufgabe besteht darin, eine multifunktionale Mehrlagenschicht auf einem transparenten Kunststoffsubstrat anzugeben, die optisch transparent, elektrisch leitfähig und kratzfest ist.

Die Erfindung löst die Aufgabe für das Verfahren durch die kennzeichnenden Merkmale des Anspruchs 1. Die Aufgabe für die multifunktionale Mehrlagenschicht wird durch die Merkmale des Anspruchs 3 gelöst. Weiterbildungen sind in dem jeweiligen Unteranspruch gekennzeichnet.

Der Kern der Erfindung besteht in dem erfindungsgemäßen Verfahren, mit dem eine multifunktionale Mehrlagenschicht auf einem transparenten Kunststoffsubstrat hergestellt werden kann.

Erfindungsgemäß wird während des gesamten Verfahrens in der Beschichtungskammer mittels einer Mikrowellen-Plasmaquelle ein starkes Plasma erzeugt. Unter der Wirkung dieses Plasmas werden die im Anspruch 1 definierten siliziumorganischen Polymerschichten abgeschieden. Unter Beibehaltung des Mikrowellen-Plasmas werden mittels Kathodenzerstäubung die definierten transparenten Metall- und/oder Metalloxidschichten hergestellt. Wesentlich ist dabei, dass der Energieeintrag durch die Mikrowellen-Plasmaquelle und die Kathodenzerstäubung derart begrenzt wird, dass das Kunststoffsubstrat durch die thermische Belastung nicht beschädigt wird. D.h. die Substrattemperatur muss für die praktisch verfügbaren Kunststoffe unter 120 °C gehalten werden.

Im Einzelnen wird verfahrensgemäß die Mehrlagenschicht plasmagestützt und in einem geschlossenen Verfahren aufgebaut. Zum Aufbau der Mehrlagenschicht wird zuerst ein Monomer, vorzugsweise eine siliziumorganische Verbindung, und Sauerstoff in dem Beschichtungsraum eingebracht und eine erste haftvermittelnden siliziumorganischen Polymerschicht abgeschieden. In der Folge wird, jeweils unter Mitwirkung einer technologisch erforderlichen Gasatmosphäre in der Beschichtungskammer, nacheinander mittels Kathodenzerstäubung und unter Beibehaltung des Mikrowellen-Plasmas eine erste ITO-Schicht (Indium-Zinn-Oxid-Schicht), danach mindestens eine transparente Metall- und/oder Metalloxidschicht und eine zweite ITO-Schicht aufgebaut. Abschließend wird eine siliziumorganische Polymerschicht in entsprechender Weise wie die erste haftvermittelnde siliziumorganische Polymerschicht abgeschieden. Wie bereits erwähnt, wird während des gesamten Verfahrens der Energieeintrag durch die Mikrowellen-Plasmaquelle und die Kathodenzerstäubung derart begrenzt, dass das Kunststoffsubstrat durch die thermische Belastung nicht beschädigt wird.

Der erfindungsgemäße Begriff "geschlossenes Verfahren" ist dabei so auszulegen, dass das Substrat innerhalb des Verfahrensablaufes zu keinem Zeitpunkt mit der Atmosphäre in Kontakt kommt. Unwesentlich ist dabei, ob das Verfahren in einer Chargenanlage oder in einer Durchlaufanlage realisiert wird.

Nach Anspruch 2 ist es auch möglich, nach der Abscheidung der transparenten Metall- und/oder Metalloxidschicht auf das Substrat eine Maske aufzulegen, die gesonderte Bereiche nicht abdeckt. In diesen Bereichen wird in einem zusätzlichen Verfahrensschritt eine weitere gleiche transparente Metall- und/oder Metalloxidschicht mit einer derartigen Dicke aufgebaut, dass diese Bereiche bei der praktischen Nutzung der Mehrlagenschicht als elektrisch kontaktierbare Elektroden dienen können. Dabei ist es auch möglich, auf diese gesonderten Bereiche spezifisches Kontaktmaterial, z.B. Gold, abzuscheiden.

Als Mikrowellen-Plasmaquelle wird in der Praxis in vorteilhafter Weise eine Hochleistungs-Mikrowellen-Plasmaquelle nach dem ECR-Prinzip (electron cyclotron resonanz) eingesetzt. Die Kathodenzerstäubung kann mittels beliebiger Magnetron-Kathodenzerstäubungs-Einrichtungen erfolgen. Dabei ist für jede Metall- bzw. Metalloxid-Komponente eine gesonderte Kathodenzerstäubungs-Einrichtung erforderlich.

Mittels des erfindungsgemäßen Verfahrens ist es möglich, auf einem transparenten Kunststoffsubstrat eine multifunktionale Mehrlagenschicht aufzubauen, die optisch transparent, elektrisch leitfähig und kratzfest ist. Nach Anspruch 3 besteht die multifunktionale Mehrlagenschicht aus einer ersten haftvermittelnden siliziumorganischen Polymerschicht mit einer Dicke von 50 bis 300 nm, einer ersten ITO-Schicht mit einer Dicke von 50 bis 300 nm, mindestens einer transparenten Metall- und/oder Metalloxidschicht mit einer Dicke von 10 bis 30 nm, einer zweiten ITO-Schicht mit einer Dicke von 50 bis 300 nm und mindestens einer abschließenden siliziumorganischen Polymerschicht mit einer Dicke von 300 bis 6000 nm. Die angegebenen Dickenbereiche ergeben sich aus den praktischen technologischen Vorgaben, insbesondere aus der vorgesehenen Anwendung der beschichteten Kunststoffsubstrate. Der relativ große Bereich der abschließenden siliziumorganischen Polymerschicht ergibt sich daraus, dass in den in der Praxis sehr unterschiedliche Forderungen gestellt werden. In den Fällen, wo das beschichtete Kunststoffsubstrat nachfolgend gesondert weiter behandelt wird, z.B. dass eine weitere harte siliziumorganische Lackschicht aufgebracht wird, reicht bereits Dicke im unteren Bereich ab 300 nm. In den Fällen, bei denen diese Schicht selbst bereits eine höhere Kratzfestigkeit aufweisen muss, dann sind Schichtdicken im oberen Bereich bis 6000 nm erforderlich.

Nach Anspruch 4 kann die transparente Metall- oder Metalloxidschicht gesonderte Bereiche aufweisen, deren Dicke größer ist, als die der übrigen Bereiche. Dabei werden diese Bereiche derart ausgebildet, dass sie als elektrisch kontaktierbare Elektroden genutzt werden können.

In überraschender Weise sind diese multifunktionalen Mehrlagenschichten, die mittels des erfindungsgemäßen Verfahren auf temperaturempfindliche Kunststoffsubstrate abgeschieden werden, optisch transparent, elektrisch leitfähig und kratzfest.

Die Funktionalität der Mehrlagenschicht bezieht sich insgesamt auf die Bereiche thermische Funktionen (Heizung über den ohmschen Widerstand, Schutz vor Strahlung u.a.), elektrische Funktionen (Abschirmung elektrischer Felder, Verhinderung elektrischer Aufladung u. a.), optische Funktionen (Transmission oder Reflexion, Entspiegelung u.a.) und mechanische Funktionen (Schutz des Kunststoffes vor mechanischen Angriffen, Barrierewirkung gegen Permeation u.a.).

Die erfindungsgemäß beschichteten transparenten Kunststoffe erfüllen auch spezifisch hohe Anforderungen aus dem Automobilbau, z.B. für beheizbare Scheiben für Kraftfahrzeuge oder beheizbare Visiere für Kopfhelme.

Die Erfindung soll nachstehend an einem Ausführungsbeispiel näher erläutert werden.

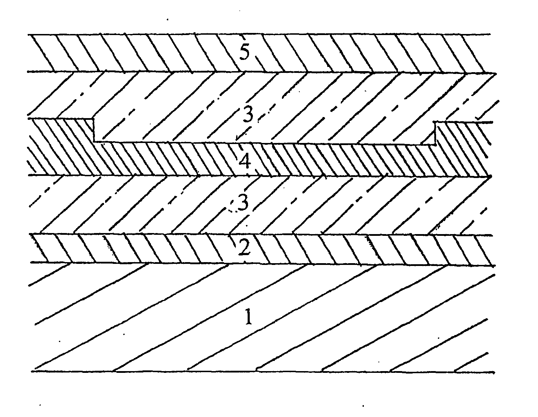

Die Zeichnung zeigt schematisch den Aufbau einer beispielhaften erfindungsgemäßen multifunktionalen Mehrlagenschicht.

Auf eine gewölbte, spritzgegossene, optisch transparente Polycarbonatscheibe, als transparentes Kunststoffsubstrat 1, mit den Abmessungen von 20 cm x 20 cm soll eine optisch transparente, elektrisch leitfähige und kratzfeste Mehrlagenschicht aufgebracht werden.

Zur Durchführung der Beschichtung steht eine Beschichtungskammer eingesetzt, in der neben anderen erforderlichen technologischen Einrichtungen mindestens ein Substrathalter, eine Hochleistungs-Mikrowellen-Plasmaquelle nach dem ECR-Prinzip und zwei Magnetron-Kathodenzerstäubungs-Einrichtungen vorhanden sind. Ein Magnetron ist mit einem ITO-Target bestückt und auf dem anderen Magnetron befindet sich ein Silber-Target.

Das transparente Kunststoffsubstrat 1 wurde mit Isopropylalkohol vorgereinigt und in die Beschichtungskammer eingebracht. Dabei wird das Kunststoffsubstrat 1 senkrecht stehend auf dem drehbaren Substrathalter positioniert, der sich unmittelbar vor den Magnetrons befindet.

Die Beschichtungskammer wird mittels eines Pumpsystems bis in den Hochvakuumbereich evakuiert. Nach dem Erreichen des Hochvakuums wird in die Beschichtungskammer Argon bis zu einem Kammerdruck von ca. 0,2 Pa eingelassen. Danach wird die Mikrowellen-Plasmaquelle gezündet. Durch das entstehende Argonplasma wird die Oberfläche des Kunststoffsubstrates 1 ca. 10 min aktiviert. Als erster, dann folgender erfindungsgemäßer Verfahrensschritt wird eine Plasmapolymerschicht als Haftvermittlungsschicht 2, bestehend aus den Elementen Silizium, Kohlenstoff und Sauerstoff erzeugt. Als Elementelieferant wird als Monomer für die Polymerisation Hexamethyldisiloxan (HMDSO) in die Beschichtungskammer eingelassen.

Über den Dampfdruck der Substanz wird ein Gasstrom von ca. 20 sccm HMDSO in die Beschichtungskammer eingeleitet. Im folgenden Plasma-Polymerisations-Prozess von ca. 10 min wird teilweise ebenfalls bis zu 20 sccm Sauerstoff über einen Massendurchflussregler zum Prozess zugeführt. Dadurch wird das entstehende Polymer teilweise in SiOx umgewandelt.

Während das ECR-Plasma weiter aktiv ist, wird der Gasstrom von HMDSO und Sauerstoff beendet und anschließend ein Magnetron mit einem Target aus ITO (Indium-Tin-Oxide), dem noch aktiven Argonplasma der ECR-Quelle zugeschaltet. Das Kunststoffsubstrat 1 auf dem drehbaren Substrathalter, wird mit einem Abstand von ca. 25 cm so vor den Quellen positioniert, dass die gewölbte Fläche, die bereits plasmaaktiviert und polymer beschichtet wurde, homogen mit einer ITO-Schicht 3 belegt wird. Die Schichtdicke der ITO-Schicht 3 beträgt im Ausführungsbeispiel ca. 200 nm. Das ECR-Plasma liefert in erfindungsgemäßer Weise während der Kathodenzerstäubung unterstützende Energie.

Mittels des zweiten Magnetrons wird nachfolgend auf die ITO-Schicht 3 eine Silberschicht 4 abgeschieden. Das Kunststoffsubstrat 1, das bisher in der Beschichtungskammer plasmaaktiviert, polymerisiert und mit einer ITO-Schicht beschichtet wurde, wird an dem Magnetron mit dem Silbertarget in einem Abstand von ca. 25 cm kontrolliert vorbei geführt und homogen mit einer ca. 15 nm dicken Silberschicht 4 belegt. Die ECR-Plasmaquelle versorgt assistierend die Silberabscheidung mit ausreichender Plasmaenergie, um eine Silberstruktur mit einem dichten Gefüge zu generieren. Das Magnetron mit dem ITO-Target ist während diesem Prozessschritt deaktiviert.

Im Ausführungsbeispiel wird nachfolgend, in Anwendung des Anspruchs 2, die bisher aufgebaute Silberschicht 4 mit einer Maske teilweise abgedeckt. In den nicht abgedeckten Bereichen wird die vorhandene Silberschicht 4 weiter aufgebaut, bis die Silberschicht 4 in diesen Bereichen eine Dicke von insgesamt ca. 400 nm aufweist. Die verstärkten Bereiche können bei der Anwendung des Kunststoffsubstrates 1 in vorteilhafter Weise als Elektroden kontaktiert werden.

Auf die Silberschicht 4, mit ihren bereichsweise unterschiedlichen Dicken, wird nachfolgend entsprechend der ersten ITO-Schicht 3 nochmals eine weitere ca. 200 nm dicke ITO-Schicht 3 aufgebracht. Dadurch ist die Silberschicht 4 zwischen den beiden ITO-Schichten 3 eingebettet und geschützt.

Zum Schutz des entstandenen Verbundes Kunststoffsubstrat/ITO/Silber/ITO und zur Vorbereitung der Aufbringung technologisch erforderlicher weiterer Schichten, wird abschließend mittels der ECR-Plasmaquelle eine abschließende Deckschicht 5 aufgebracht, die in ihren obersten Lagen SiOx strukturiert ist. Danach können in gesonderten Verfahrensschritten weitere Schichten, insbesondere Schutzschichten, z.B. zum erhöhten Schutz der multifunktionalen Mehrlagenschicht gegen mechanische Belastungen wie Kratzen u.s.w., aufgebracht werden.

Das so beschichtete Kunststoffsubstrat 1 aus Polycarbonat mit der erfindungsgemäßen Beschichtung als Funktionsschicht ist außerordentlich hart, weist eine gute gleichmäßige optische Transparenz auf und kann elektrisch hoch belastet werden. Z.B. kann beim Anlegen einer Gleichspannung von 12 V an die als Elektroden ausgebildeten Bereichen und dem Einbringen entsprechender elektrischer Leistung das Kunststoffsubstrat 1 von Raumtemperatur auf ca. 60 °C aufgeheizt werden. Dabei bleibt das Polycarbonat-Substrat und die Beschichtung so transparent, dass mindestens 70 % Licht des optisch sichtbaren Bereiches hindurch tritt.

Der Erfindung ist nicht auf die in der Beschreibung dargelegten Verfahrensschritte und Schichten begrenzt. So fallen unter die Erfindung auch fachmännische Abwandlungen bei der Auswahl der Metall- und/oder Metalloxidschichten oder der Dickenparameter. Die Erfindung kann insbesondere an konkrete Qualitätsanforderungen angepasst werden.

## Patentansprüche

1. Verfahren zur Herstellung einer Mehrlagenschicht auf einem transparenten Kunststoffsubstrat (1), die optisch transparent, elektrisch leitfähig und kratzfest ist, **dadurch gekennzeichnet, dass** die Mehrlagenschicht plasmagestützt und in einem geschlossenen Verfahren in einer Beschichtungskammer aufgebaut wird, bei dem mittels einer Mikrowellen-Plasmaquelle ein Plasma erzeugt und während des Verfahrensablaufes ständig aufrechterhalten wird, dass nachfolgend in die Beschichtungskammer ein Monomer, vorzugsweise eine siliziumorganische Verbindung, und Sauerstoff eingebracht und eine erste haftvermittelnden siliziumorganische Polymerschicht (2) abgeschieden wird, dass in der Folge mittels Kathodenzerstäubung eine erste ITO-Schicht (Indium-Zinn-Oxid-Schicht) (3), eine transparente Metall- und/oder Metalloxidschicht und eine zweite ITO-Schicht (3) aufgebaut werden und dass abschließend eine siliziumorganische Polymerschicht (5) in entsprechender Weise wie die erste haftvermittelnde siliziumorganische Polymerschicht (2) abgeschieden wird.

2. Verfahren nach Anspruch 1, **dadurch gekennzeichnet, dass** nach der Abscheidung der transparenten Metall- und/oder Metalloxidschicht auf das Kunststoffsubstrat (1) eine Maske aufgelegt wird, welche gesonderte Bereiche nicht abdeckt, dass in diesen Bereichen in einem zusätzlichen Verfahrensschritt eine weitere transparente Metall- und/oder Metalloxidschicht mit einer Dicke aufgebaut, dass diese Bereiche als elektrisch kontaktierbare Elektroden genutzt werden können, dass die Maske entfernt und die weiteren Schichten aufgebaut werden.

3. Multifunktionale Mehrlagenschicht auf einem transparenten Kunststoffsubstrat (1), die optisch transparent, elektrisch leitfähig und kratzfest ist, bestehend aus einer ersten haftvermittelnden siliziumorganischen Polymerschicht (2) mit einer Dicke von 50 bis 300 nm, einer ersten ITO-Schicht (3) mit einer Dicke von 50 bis 300 nm, mindestens einer transparenten Metall- und/oder Metalloxidschicht mit einer Dicke von 10 bis 30 nm, einer zweiten ITO-Schicht (3) mit einer Dicke von 50 bis 300 nm und mindestens einer abschließenden siliziumorganischen Polymerschicht (5) mit einer Dicke von 300 nm bis 6000 nm.

4. Mehrlagenschicht nach Anspruch 3, **dadurch gekennzeichnet, dass** die transparente Metall- oder Metalloxidschicht gesonderte Bereiche aufweist, deren Dicke größer ist, als die der übrigen Bereiche, derart dass diese Bereiche als elektrisch kontaktierbare Elektroden genutzt werden können.

## Claims

1. Process for producing a multi-ply layer on a transparent plastics substrate (1), the layer being optically transparent, electrically conductive and scratch-resistant, **characterized in that** the multi-ply layer is constructed by a plasma-assisted method and in a coating chamber by an enclosed process in which a plasma is produced by means of a microwave plasma source and is continuously maintained during the course of the process, and that a monomer, preferably an organosilicon compound, and oxygen are subsequently introduced into the coating chamber and a first adhesion-promoting organosilicon polymer layer (2) is deposited, and then cathode sputtering is used to construct a first ITO layer (indium-tin-oxide layer) (3), and a transparent layer of metal and/or of metal oxide and a second ITO layer (3), and that finally an organosilicon polymer layer (5) is deposited in the manner used for the first adhesion-promoting organosilicon polymer layer (2).

2. Process according to Claim 1, **characterized in that** after deposition of the transparent layer of metal and/or of metal oxide onto the plastics substrate (1) a mask is superimposed which does not protectively cover particular regions, and that in these regions another transparent layer of metal and/or of metal oxide is constructed in an additional step of the process with a thickness such that these regions can be utilized as electrically contactable electrodes, and that the mask is removed and the other layers are constructed.

3. Multifunctional multi-ply layer on a transparent plastics substrate (1), the layer being optically transparent, electrically conductive and scratch - resistant, and composed of a first adhesion-promoting organosilicon polymer layer (2) with a thickness of from 50 to 300 nm, of a first ITO layer (3) with a thickness of from 50 to 300 nm, of at least one transparent layer with a thickness of from 10 to 30 nm of metal and/or of metal oxide, of a second ITO layer (3) with a thickness of from 50 to 300 nm, and of at least one final organosilicon polymer layer (5) with a thickness of from 300 nm to 6 000 nm.

4. Multi-ply layer according to Claim 3, **characterized in that** the transparent layer of metal or of metal oxide has particular regions whose thickness is greater than that of the other regions, so that these regions can be utilized as electrically contactable electrodes.

## Revendications

1. Procédé de fabrication d'une couche stratifiée électriquement conductrice, optiquement transparente et résistante aux rayures sur un support transparent (1) en matière synthétique, **caractérisé en ce que** la couche stratifiée est réalisée avec l'assistance d'un plasma dans une chambre de revêtement par un procédé fermé lors duquel une source de plasma à micro-ondes produit un plasma qui est maintenu à un niveau constant pendant le déroulement du procédé, **en ce qu'**un monomère et de préférence un composé organique du silicium et de l'oxygène sont ensuite apportés dans la chambre de revêtement et une première couche polymère d'adhérence (2) en un composé organique du silicium est déposée, **en ce qu'**ensuite, une première couche d'ITO (couche d'oxyde d'indium et d'étain) (3), une couche transparente en métal et/ou en oxyde métallique et une deuxième couche d'ITO (3) sont formées par pulvérisation cathodique et **en ce que**, pour terminer, une couche polymère (5) d'un composé organique du silicium est déposée en correspondance à la première couche polymère d'adhérence (2) en un composé organique du silicium.

2. Procédé selon la revendication 1, **caractérisé en ce qu'**après le dépôt de la couche transparente en métal et/ou en oxyde métallique sur le support en matière synthétique (1), on pose un masque qui ne recouvre pas certaines zones, **en ce que** dans une étape supplémentaire de traitement, une autre couche transparente en métal et/ou en oxyde métallique est formée dans ces zones à une épaisseur qui permet d'utiliser ces zones comme électrodes électriquement connectables et **en ce que** le masque est retiré et les autres couches sont formées.

3. Couche stratifiée multifonctionnelle optiquement transparente, électriquement conductrice et résistante aux rayures sur un support transparent en matière synthétique (1), constituée d'une première couche polymère d'adhérence (2) en un composé organique du silicium d'une épaisseur de 50 à 300 nm, d'une première couche d'ITO (3) d'une épaisseur de 50 à 300 nm, d'au moins une couche transparente en métal et/ou en oxyde métallique d'une épaisseur de 10 à 30 nm, d'une deuxième couche d'ITO (3) d'une épaisseur de 50 à 300 nm et d'au moins une couche polymère de finition (5) en un composé organique du silicium d'une épaisseur de 300 nm à 6000 nm.

4. Couche stratifiée selon la revendication 3, **caractérisée en ce que** différentes zones de la couche transparente en métal et/ou en oxyde métallique ont une épaisseur supérieure à celle des autres zones de manière à pouvoir être utilisées comme électrodes électriquement connectables.
